(19) Europäisches Patentamt
European Patent Office
Office européen des brevets

(11) **EP 3 364 461 A1**

(12) **DEMANDE DE BREVET EUROPEEN**

(43) Date de publication:
**22.08.2018 Bulletin 2018/34**

(21) Numéro de dépôt: **17202863.1**

(22) Date de dépôt: **21.11.2017**

(51) Int Cl.:
**H01L 29/16** (2006.01)  **H01M 4/62** (2006.01)
**C01B 32/194** (2017.01)  **C23C 16/26** (2006.01)
**H01B 1/04** (2006.01)  **H01B 5/14** (2006.01)
**H01B 13/00** (2006.01)

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**MA MD**

(30) Priorité: **22.11.2016 FR 1661352**

(71) Demandeur: **Commissariat à l'Energie Atomique et aux Energies Alternatives**
**75015 Paris (FR)**

(72) Inventeurs:
• **LE POCHE, Hélène**
  **38000 GRENOBLE (FR)**
• **CARELLA, Alexandre**
  **64110 MAZERES-LEZONS (FR)**
• **DIJON, Jean**
  **38000 GRENOBLE (FR)**
• **OKUNO, Hanako**
  **38000 GRENOBLE (FR)**
• **RAUX, Emilie**
  **38000 GRENOBLE (FR)**

(74) Mandataire: **Nony**
  **11 rue Saint-Georges**
  **75009 Paris (FR)**

(54) **PROCÉDÉ DE DOPAGE DE GRAPHÈNE**

(57) La présente invention concerne un procédé utile pour préparer une couche de graphène transparente et de conductivité électrique améliorée et stabilisée, ledit procédé comprenant au moins les étapes consistant à :
(i) disposer d'au moins une couche de graphène transparente et possédant une résistance carrée, RDini,
(ii) doper au moins une zone de ladite couche de graphène pour former une zone de graphène dopée ayant une résistance carrée stabilisée, R□∞, de valeur inférieure à R□ini.
caractérisé en ce que l'étape (ii) est réalisée par pulvérisation, en surface d'au moins ladite zone de ladite couche de graphène (i), d'au moins un dopant choisi parmi les sels et complexes organométalliques de platine ou de palladium de degré d'oxydation +IV ou +II et en ce que de préférence la zone de graphène dopé possède en outre une valeur de transmittance supérieure à 85% sur l'ensemble du spectre du visible.

**EP 3 364 461 A1**

**EP 3 364 461 A1**

**Description**

La présente invention est relative à un procédé utile pour accroître, par dopage chimique, la conductivité électrique d'un graphène transparent tout en lui conservant une transparence satisfaisante. Le graphène ainsi dopé s'avère tout particulièrement intéressant pour constituer des électrodes conductrices transparentes pour des dispositifs d'affichage ou des cellules solaires.

Actuellement, les matériaux transparents conducteurs privilégiés pour ces utilisations sont les oxydes conducteurs transparents (TCOs) et plus particulièrement d'oxyde d'indium dopé à l'étain (ITO). Toutefois, l'utilisation de ces matériaux présente un certain nombre d'inconvénients, notamment au regard du coût élevé et fluctuant de l'indium et de la grande fragilité mécanique de l'ITO, incompatible avec des applications sur substrats flexibles.

Or, le graphène, qui combine une bonne conductivité électrique et une transparence élevée, est précisément très intéressant sur ces deux aspects coût et flexibilité. Il peut donc constituer une alternative très avantageuse à l'ITO sous réserve de pouvoir maximiser sa conductivité électrique tout en conservant une transmittance optique suffisamment élevée.

Plus précisément, le graphène monocouche est un matériau transparent avec une absorbance optique réduite dans le visible de l'ordre de 2,3 %. Sa conductivité électrique ($\sigma$) est corrélée à la densité de porteurs de charge (n) et à la mobilité de ces porteurs ($\mu$) selon la relation $\sigma = e \times n \times \mu$ (e : charge élémentaire). En conséquence, pour constituer une alternative avantageuse aux autres oxydes conducteurs transparents comme l'ITO, cette conductivité améliorée devrait être corrélée à une résistance carré (R$\square$) réduite tout en demeurant couplée à une transmittance sur l'ensemble du spectre visible supérieure ou égale à 85%.

Il est connu que le choix d'un graphène monocouche de haute qualité cristalline (forte mobilité), typiquement un graphène élaboré par CVD (« *Chemical Vapor Déposition* » en anglais) est déterminant pour obtenir des performances électriques couplées à des performances optiques satisfaisantes. Quelques monocouches de graphène peuvent aussi être empilées en nombre limité pour conserver une bonne transparence.

Néanmoins, les meilleures monocouches de graphène présentent une résistance carrée de plusieurs centaines d'ohms/carré. Il demeure donc nécessaire de considérer un dopage de cette monocouche de graphène pour diminuer sa résistance électrique et donc augmenter sa conductivité électrique.

Parmi les différentes techniques de dopage existantes, le dopage chimique *ex-situ* (post-élaboration du graphène) par transfert de charge conduit aux meilleures performances électriques car la structure cristalline du graphène (hybridation sp2) n'est pas modifiée par le dopage. La conductivité électrique du graphène peut ainsi être améliorée en augmentant la densité de porteurs de charge.

Plusieurs natures chimiques de dopants ont déjà été considérées pour le graphène. Ainsi, les dopants de type p les plus couramment utilisés et parmi les plus efficaces correspondent à des acides, tels que par exemple $HNO_3$ et HCl, comme décrit dans la publication Bae et al., Nature Nanotechnology 5, 2010, 574, et la demande US 2015/0162408 A1, et/ou à des oxydants tels que les sels métalliques à base par exemple d'Au ($AuCl_3$, $HAuCl_4$, ...) comme décrit dans les publications Kim et al., Nanotechnology, 21, 2010, 285205, Kobayashi et al., Appl. Phys. Lett., 102, 2013, 023112, et Bae et al., Nature Nanotechnology, 5, 2010, 574, ou de Fe ($FeCl_3$, ...) comme décrit dans la publication Khrapach et al., Adv. Mater., 24 2012, 2844. Pour leur part, les documents WO 2014/065534 A1 et CN 102180463 mentionnent la possible utilisation de sels ou de complexes à base de Pt ($HPtCl_4$, $H_2PtCl_6$) ou de Pd ($H_2PdCl_6$, Pd(OAc)$_2$) sans donner de performances électriques en termes d'efficacité du dopage.

Dans la grande majorité des cas, ces dopants sont mis en oeuvre, en dispersion ou solubilisés, dans des solutions liquides qui sont déposées à la surface du graphène par trempage ou immersion (« dipping ») comme décrit dans la demande US 2015/0162408 A1 ou éventuellement par « spin-coating » où la solution de dopage est étalée sur la surface du graphène en rotation comme décrit dans la publication Kim et al., Nanotechnology, 21, 2010, 285205. Les demandes WO 2014/065534 A1 et CN 104528698 font référence à un dépôt de la solution de dopage à la surface du graphène par « dropping », c'est-à-dire dépôt de la solution localement goutte par goutte. Quant aux demandes CN 104528698 et CN 104607344, elles décrivent un dépôt de la solution de dopage par pulvérisation « spray » qui consiste à nébuliser la solution liquide véhiculant l'agent dopant en un brouillard de fines gouttelettes au-dessus de l'échantillon.

Malheureusement, ces techniques de dopage ne s'avèrent pas totalement satisfaisantes pour les raisons suivantes.

Tout d'abord, l'exigence d'homogénéité du graphène dopé sur de grandes surfaces n'est le plus souvent pas satisfaite avec ces techniques de dépôt et tout particulièrement avec le « spin-coating » ou le « dropping ».

D'autre part, l'obtention simultanée de bonnes performances électriques couplées à des performances optiques satisfaisantes reste, dans la grande majorité des cas, non concurrentielle par rapport à l'ITO. L'achèvement de cette exigence requiert clairement de pouvoir contrôler la quantité de dopants déposée à la surface du graphène. Or, il est difficile d'ajuster cette quantité. En effet, classiquement, on cherche à minimiser cette quantité de dopants, d'une part pour ne pas trop dégrader la transparence optique et d'autre part pour conserver une bonne efficacité de dopage. En effet, un excès de dopants est considéré comme étant de nature à dégrader la conductivité électrique en diminuant excessivement la mobilité.

Enfin, le problème principal du dopage chimique réside dans l'instabilité des dopants. Pour la plupart des techniques de dopage, l'efficacité du dopage n'est pas maintenue lors du vieillissement temporel des échantillons dans les conditions ambiantes (air, humidité) ou lors d'un traitement en température (typiquement pour T ≥ 100 °C), rendant le dopage incompatible avec les technologies de fabrication des électrodes transparentes.

Concernant ce dernier aspect, il a été proposé de stabiliser les dopants en les encapsulant à l'aide d'une couche de graphène qui est superposée à la couche de graphène dopée comme décrit dans les demandes US 2015/0162408 et CN 10 4528 698. En fait, dans la majorité des cas, ce type d'empilement n'est pas réalisable en utilisant les techniques classiques de transfert du graphène par voie humide *via* un polymère support sacrificiel comme décrit dans la publication Suk *et al.,* ACS Nano, 5, 2011, 6916. En effet, les dopants déposés sur la couche inférieure de graphène sont éliminés lors du transfert de la couche supérieure de graphène. Une autre alternative proposée consiste à stabiliser les dopants en ajoutant une couche organique hydrophobe à la surface du graphène dopé telle que décrite dans la demande WO 2014/065534 A1. Malheureusement, il se pose alors le problème de la diminution de la transmittance optique de l'empilement et de la façon de former cette couche supérieure sans éliminer les dopants.

En conséquence, il n'existe à ce jour, à la connaissance des inventeurs, aucune méthode de dopage d'une couche de graphène permettant d'accéder à un graphène dopé de manière homogène, demeurant doté d'une bonne transparence et dont le dopage est efficace et stabilisé.

La présente invention a précisément pour objet de proposer une nouvelle méthode de dopage répondant à l'ensemble de ces exigences.

En particulier, la présente invention vise à proposer un procédé utile pour accéder à un dopage chimique efficace et stabilisé, d'une couche de graphène transparente tout en préservant à cette couche une transmittance d'au moins 85%.

Elle vise en outre à proposer une nouvelle technique de dopage qui soit compatible avec une mise en oeuvre sur des couches de carbone à grande échelle notamment avec des méthodes au défilé de type « roll to roll » et supportées sur des substrats flexibles.

Plus précisément, selon un premier aspect, la présente invention concerne un procédé utile pour préparer une couche de graphène transparente et de conductivité électrique améliorée et stabilisée, ledit procédé comprenant au moins les étapes consistant à :

(i) disposer d'au moins une couche de graphène transparente et possédant une résistance carrée, RDini et
(ii) doper au moins une zone de ladite couche de graphène pour former une zone de graphène dopée ayant une résistance carrée stabilisée, R□∞, de valeur inférieure à R□ini,

caractérisé en ce que l'étape (ii) est réalisée par pulvérisation, en surface d'au moins ladite zone de ladite couche de graphène (i), d'au moins un dopant choisi parmi les sels et complexes organométalliques de platine ou de palladium de degré d'oxydation +IV ou +11.

Avantageusement, la quantité en dopant $Q_D$ est ajustée pour former une zone de graphène dopée et dotée de la résistance carrée stabilisée et minimisée, R□∞ attendue.

Selon une variante préférée, la zone de graphène dopée possède en outre une valeur de transmittance supérieure à 85% sur l'ensemble du spectre du visible.

Au sens de l'invention une résistance carrée stabilisée, ou encore R□∞, est une résistance carrée dont la valeur ne s'accroît pas significativement, en particulier de plus de 8 % de sa valeur lors du vieillissement temporel de la couche de graphène dopée, dans les conditions ambiantes (air, humidité).

Contre toute attente, les inventeurs ont en effet constaté, que sous réserve du choix de dopants particuliers, d'un ajustement de leur quantité au niveau du dopage et d'un mode de dopage conforme à l'invention, il s'avère possible d'accéder à des couches de graphène dopées qui sont dotées d'un gain de conductivité significatif et stabilisé dans le temps.

Il est rappelé que la résistance carrée, dite encore « résistance surfacique » (appelée « sheet résistance » en anglais), peut être définie par la formule suivante :

$$R\square = \frac{\rho}{e} = \frac{1}{\sigma.e}$$

dans laquelle :

- e représente l'épaisseur du film conducteur (en cm) ;
- σ représente la conductivité du film (en S/cm) (σ=1/ρ) ; et

- p représente la résistivité du film (en $\Omega$.cm).

Il est également rappelé que le dopage d'une couche de graphène a pour effet immédiat de réduire la résistance carrée R□ini, de cette couche à une valeur R□D.

Toutefois, comme évoqué dans le préambule du présent texte, il n'est généralement pas possible de conserver cette valeur R□D, mesurée juste après dépôt. Elle est altérée significativement au cours du vieillissement temporel de la couche de graphène dopée et ceci se traduit par une perte progressive de l'efficacité du dopage.

Le procédé selon l'invention permet précisément de conserver dans le temps l'efficacité du dopage.

La résistance carrée stabilisée, R□∞ obtenue selon le procédé selon l'invention, figure donc une valeur de RD stable dans le temps.

Ainsi, le procédé de l'invention permet avantageusement de garantir un gain de conductivité à la zone de graphène dopé tout au long de son vieillissement.

Ce gain d'efficacité est notamment obtenu selon l'invention grâce à la mise en oeuvre d'une quantité en excès de dopants.

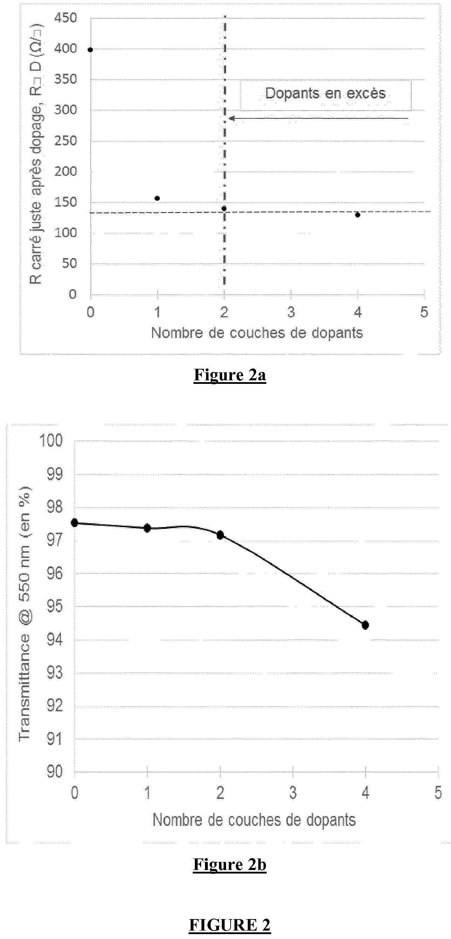

Au sens de l'invention, l'expression « quantité en excès de dopant » fait référence à des quantités en dopant supérieures ou égales à la quantité minimale requise en dopants au-dessus de laquelle la valeur de R□D ne varie plus ou ne diminue plus voire ne décroît pas plus de 8% de sa valeur, lorsque des dopants sont rajoutés à la surface du graphène (figure 2a).

Par contre, l'efficacité du dopage après stabilisation est d'autant plus importante ou R□∞ est d'autant plus faible que la quantité de dopants est élevée.

En outre, selon un mode préféré de l'invention, cette quantité en excès de dopants présents au sein de la zone de graphène dopé, qui est efficace pour procurer, à ladite zone de graphène dopé une résistance carrée R□∞ minimisée est en outre efficace pour permettre à la zone de graphène dopé, de manifester une transparence et en particulier d'une transmittance d'au moins 85% sur l'ensemble du spectre du visible.

Avantageusement, la couche de graphène de l'étape (i) du procédé est supportée par un substrat.

De préférence, le substrat est transparent ou translucide dans le domaine du visible ou de l'infra-rouge et de préférence choisi parmi le verre, polyéthylène téréphtalate (PET), polycarbonate (PC), polyimide (PI), polyéthylène naphtalate (PEN), polydiméthylsiloxane (PDMS), polystyrène (PS), polyether sulfone (PES), du silicium recouvert d'une couche d'oxyde telle que SiOx, Al$_2$Ox, ou d'une couche de nitrure, de préférence choisi parmi du verre et du polyéthylène téréphtalate.

La couche de graphène de l'étape (i) est en particulier un graphène monocouche élaboré par une technique de dépôt chimique en phase vapeur (CVD) (« Chemical Vapor Déposition »).

Selon une variante de réalisation, la couche de graphène de l'étape (i) est directement au contact du substrat.

Selon une autre variante de réalisation, la couche de graphène est au contact d'une couche de graphène dopé et de transmittance dans le domaine du visible au moins égale à 90%, qui est intercalée entre ledit substrat et ladite couche de graphène à doper.

Selon encore une autre variante de réalisation, la couche de graphène est au contact d'une couche de graphène non dopé, avantageusement transparente et notamment de transmittance dans le domaine du visible au moins égale à 97% , qui est intercalée entre ledit substrat et ladite couche de graphène à doper.

Avantageusement, le dopant est choisi parmi :

- les sels de platine ou de palladium de formules :

$$A_2MX_6, MX_4, A_2MX_4 \text{ et } MX_2$$

dans lesquelles :

- A est un atome d'hydrogène, un groupe NH$_4$, un atome de sodium, un atome de lithium ou un atome de potassium ;
- X est un atome de fluor, un atome de chlore, un atome de brome ou un atome d'iode ; et
- M est un atome de platine ou un atome de palladium de degré d'oxydation +IV ou +11.

De préférence, le dopant est choisi parmi les sels de PtCl$_4$, H$_2$PtCl$_6$, H$_2$PtCl$_4$ PtCl$_2$, H$_2$PdCl$_6$, PdCl$_2$, K$_2$PdCl$_4$... et leurs mélanges. Selon un mode de réalisation préféré, le ou les dopants considérés selon l'invention sont mis en oeuvre au sein d'une solution liquide.

Selon un mode de réalisation préféré, la solution liquide de dopant(s) est pulvérisée par l'intermédiaire d'une buse fixe ou d'une buse mobile.

De préférence, la solution liquide de dopant(s) est pulvérisée de manière automatique au moyen d'une buse soumise à des vibrations ultrasoniques.

En particulier, l'opération de pulvérisation au niveau de la couche de graphène peut être réalisée en une fois ou répétée une à plusieurs fois.

Selon un mode de réalisation particulier, un masque pochoir peut être intercalé entre la buse et la couche de graphène à doper pour délimiter une zone de dopage.

Selon une variante de réalisation préférée, l'étape (ii) du procédé selon l'invention est réalisée en mode dynamique selon une technique de dopage au défilé et en particulier de type « roll-to-roll ».

Avantageusement, le substrat supportant la couche de graphène traitée en étape (ii), est chauffé à une température propice à l'élimination du milieu solvant de la solution liquide de dopant.

Avantageusement, le procédé selon l'invention comprend en outre les étapes supplémentaires consistant à :

(ia) disposer de la valeur de la transmittance $T_{ini}$ de la couche de graphène considérée en étape (i) préliminairement à la réalisation de l'étape (ii) ;
(iia) mesurer la valeur de la transmittance $T_D$ de ladite couche de graphène dopée juste après l'étape dopage (ii) ; et
(iib) apprécier la quantité de dopants par comparaison de la transmittance $T_D$ à la transmittance $T_{ini}$, une valeur $T_D$ inférieure à une valeur $T_{ini}$ étant représentative d'un dopage effectif.

Les mesures de transmittance peuvent être réalisées par une mesure en ligne au moyen d'un laser visible ou proche infrarouge.

Avantageusement, le procédé selon l'invention comprend en outre consécutivement à l'étape de dopage (ii), et si présente de l'étape (iib), une étape (iii) de stabilisation de la concentration en sels ou complexes organométalliques de platine ou de palladium de degré d'oxydation +IV ou +II au niveau de la couche de graphène dopée.

Selon une variante de réalisation, l'étape (iii) consiste en une opération de stabilisation temporelle. Si besoin, cette stabilisation peut être accélérée par voie thermique. La mise en oeuvre d'une telle étape relève clairement des compétences de l'homme de l'art.

Avantageusement, le procédé selon l'invention comprend, en outre, consécutivement à l'étape de dopage (ii), et si présente de l'étape (iii) de stabilisation telle que définie précédemment, au moins une étape (iv) consistant à transférer, par voie sèche ou par voie humide, une couche de graphène possédant une transmittance au moins égale à 97% notamment dans le domaine du visible, en surface de la couche de graphène dopé obtenue à l'issue de l'étape (ii).

De préférence, le procédé comprend consécutivement à l'étape (iii) ou (iv) une mesure de la valeur de la transmittance $T_\infty$ de ladite couche de graphène dopé et stabilisé.

Selon une variante de réalisation de l'invention, le dopant est le $PtCl_4$, et la couche de graphène dopé et stabilisé correspondante possède, une résistance carrée stabilisée, $R\square\infty$ inférieure ou égale à 350 $\Omega/\square$, et de préférence inférieure ou égale à 300 $\Omega/\square$, voire inférieure ou égale à 200 $\Omega/\square$ et avantageusement une transmittance T supérieure à 85% sur l'ensemble du spectre du visible.

Selon un autre aspect, la présente invention a trait à un matériau comprenant au moins une couche de graphène dopé obtenu par le procédé tel que défini selon l'invention.

Selon encore un autre aspect, la présente invention concerne l'utilisation d'une couche de graphène dopé obtenu par le procédé tel que défini selon l'invention pour fabriquer des écrans ultrafins et flexibles, des écrans tactiles, des batteries, des cellules solaires, des biocapteurs, des dispositifs électroniques ou opto-électroniques dans le domaine du visible ou de l'infra-rouge, des dispositifs spintroniques, des électrodes transparentes conductrices destinées à être incorporées dans des dispositifs de visualisation tel que des afficheurs, des écrans d'affichage, des écrans plats, et des diodes électroluminescentes organiques (OLED) ou dans des dispositifs photovoltaïques.

Selon encore un autre aspect, la présente invention a pour objet un dispositif, en particulier tel que listé ci-dessus, comprenant un graphène dopé obtenu par le procédé tel que défini selon l'invention ou un matériau tel que défini selon l'invention.

## I- PROCEDE DE DOPAGE SELON L'INVENTION

Comme il ressort de ce qui précède, le procédé permet d'augmenter significativement et de manière stabilisée la conductivité électrique d'une couche de graphène transparente tout en permettant à celle-ci de conserver des propriétés de transmittance avantageuses.

Pour se faire, ce procédé met en oeuvre une technique de dopage chimique par transfert de charge impliquant d'une part, le choix d'un agent dopant particulier, d'autre part, le choix d'un mode de dopage spécifique, et enfin l'ajustement d'une concentration spécifique en dopants au niveau de la couche de graphène dopé.

## a) Couche de graphène à doper

Comme précisé ci-dessus, cette couche de graphène est transparente.

Au sens de l'invention, l'expression transparence ou transmittance n'est pas limitée au domaine du visible. Elle peut également caractériser une transparence dans le domaine de l'infra-rouge.

Toutefois, selon une variante préférée, cette transparence caractérise une transparence sur l'ensemble du domaine du visible.

Plus précisément, la zone de graphène à doper selon l'invention possède une transmittance sur l'ensemble du spectre du visible au moins égale à 85%.

De préférence, la couche de graphène à doper possède une valeur de transmittance supérieure ou égale à 90% et de préférence supérieure à 95% sur l'ensemble du spectre du visible.

Il est rappelé que la transmittance d'une structure donnée représente l'intensité lumineuse traversant la structure sur le spectre du visible.

Elle peut être mesurée par spectrométrie UV-Visible, par exemple à l'aide d'une sphère d'intégration sur un spectromètre de type Varian Carry.

La transmittance sur le spectre du visible correspond à la transmittance pour des longueurs d'ondes comprise entre 350 nm et 800 nm.

La couche de graphène considérée en étape (i) est avantageusement un graphène monocouche élaboré par CVD « *Chemical Vapor Déposition* » et possède avantageusement une valeur de transmittance supérieure à 95 %. De nombreuses techniques de ce type sont disponibles et l'invention n'est pas limitée à l'une d'entre elles. L'ensemble de ces techniques visent à former la couche de graphène sur un substrat de croissance temporaire comportant une couche catalytique telle que le cuivre et le platine. Le transfert de la couche de graphène sur un substrat cible, peut être ensuite réalisé, selon une technique de transfert humide conventionnelle ou par voie sèche notamment tel que détaillé ci-après.

La couche de graphène considérée en étape (i) est avantageusement supportée par un substrat.

De manière générale, dans le cadre de la présente invention, le terme « substrat » fait référence à une structure de base solide sur une des faces de laquelle est déposée au moins une couche de graphène.

Le substrat peut être de diverses natures.

Il peut s'agir d'un substrat flexible ou rigide.

Le substrat peut être transparent, translucide, opaque ou coloré. Il peut également s'agir d'un substrat temporaire tel qu'énoncé ci-dessus.

Toutefois, dans le cas où la couche de graphène dopé selon l'invention est destinée à une mise en oeuvre dans un dispositif devant satisfaire à des propriétés optiques de transparence, par exemple pour un écran tactile ou un dispositif de visualisation, etc, ce substrat cible est avantageusement formé à partir d'un matériau transparent.

Ce substrat peut être ainsi un substrat en verre ou en polymères transparents tels que le polycarbonate, les polyoléfines, le polyéthersulfone, le polysulfone, les résines phénoliques, les résines époxy, les résines polyesters, les résines polyimides, les résines polyétheresters, les résines polyétheramides, le polyvinyl(acétate), le nitrate de cellulose, l'acétate de cellulose, le polystyrène, les polyuréthanes, le polyacrylonitrile, le polytétrafluoroéthylène, les polyacrylates tels que le polyméthacrylate de méthyle, le polyarylate, les polyétherimides, les polyéthers cétones, les polyéthers éthers cétones, le polyfluorure de vinylidène, les polyesters tels que le polyéthylène téréphtalate ou polyéthylène naphtalate, le polydiméthylsiloxane, les polyamides, la zircone, ou leurs dérivés, ou encore du silicium recouvert d'une couche de nitrure ou d'une couche d'oxyde tel que par exemple $SiO_x$, ou $Al_2O_x$.

Selon une première variante, la couche de graphène considérée en étape (i) est directement supportée par un substrat.

Ainsi, selon un mode de réalisation préféré, le graphène à doper de l'étape (i) du procédé selon l'invention est un graphène mono-couche disposé en surface et directement au contact d'un substrat constitué d'un matériau choisi parmi le verre, polyéthylène téréphtalate (PET), polycarbonate (PC), polyimide (PI), polyéthylène naphtalate (PEN), polydiméthylsiloxane (PDMS), polystyrène (PS), polyether sulfone (PES), du silicium recouvert d'une couche d'oxyde telle que $SiO_x$, $Al_2O_x$, ..., et de préférence est choisi parmi du verre et du polyéthylène téréphtalate (PET).

Selon une autre variante, la couche de graphène considérée en étape (i) est au contact d'une couche de graphène non dopée et transparente, qui est intercalée entre ledit substrat et ladite couche de graphène à doper. Dans ce mode de réalisation, le graphène est un graphène bi-couche et le dopage concerne la couche externe de graphène.

Selon encore une autre variante, la couche de graphène considérée en étape (i) est au contact d'une couche de graphène dopée et transparente qui est intercalée entre ledit substrat et ladite couche de graphène à doper.

Ainsi, selon cette variante, le substrat est revêtu d'une première couche de graphène avec dopant « GD », revêtue elle-même d'une couche de graphène non dopé « G » et dont l'architecture peut être symbolisée par « GDG ».

Avantageusement, la première couche de graphène avec dopant « GD » a pu elle-même être au préalable, préparée par dopage d'une couche de graphène « G » selon le procédé de l'invention.

Plus précisément, ce type d'architecture « GDG » empilée au niveau d'un substrat peut être obtenu selon l'enchaînement de réactions suivantes.

Une première monocouche de graphène supportée sur un substrat (nommé substrat cible 1) est dopée par une solution liquide de dopant conformément au procédé de l'invention. Cet ensemble formé du substrat cible 1 et de la première couche de graphène dopée peut alors constituer un substrat cible (nommé substrat cible 2) distinct du substrat cible 1.

Une deuxième couche de graphène, identique ou distincte de la première couche, est ensuite transférée, sur la première couche dopée supportée par le substrat cible 1 selon un procédé conventionnel de transfert notamment en voie humide ou, de préférence, par voie sèche afin de limiter la perte en dopants au cours d'un tel transfert.

Bien entendu, il est possible d'envisager d'empiler selon cette technique, plusieurs couches de graphène dopé « GD », et/ou de graphène non dopé « G », intercalées entre le matériau constituant le substrat et la couche de graphène à doper à l'image par exemple d'une architecture symbolisée par « GDGDG » et représentative d'un empilement contigü de deux couches de graphène avec dopant, intercalé entre le substrat et la couche de graphène à doper.

Il importe en revanche que le système multicouche ainsi constitué possède la propriété de transmittance requise selon l'invention à savoir d'au moins 85% et notamment sur l'ensemble du spectre dans le visible.

Le procédé selon l'invention est donc également utile pour préparer un empilement de couches de graphène dopé avec un dopant conforme à l'invention.

### b) Solution liquide de dopants

Comme exposé ci-dessus, le procédé selon l'invention met en oeuvre, à titre de dopant, au moins un sel ou un complexe organométallique de platine ou de palladium de degré d'oxydation +IV ou +11.

Comme il ressort des exemples ci-après, les inventeurs ont, contre toute attente, constaté que les dopants considérés selon l'invention sont déterminants pour obtenir une amélioration de la conductivité électrique du graphène stabilisée temporellement en termes d'efficacité.

Sans vouloir être liée par la théorie, cette stabilisation progressive au dopage est vraisemblablement associée à une réorganisation chimique et morphologique des espèces dopantes à la surface du graphène.

De manière avantageuse, les sels ou complexes organométalliques de platine ou de palladium de degré d'oxydation +IV ou +II convenant à l'invention conduisent à des arrangements bidimensionnels, potentiellement responsables du phénomène de stabilité. A l'inverse, les sels d'Au se réarrangent à la surface du graphène pour former des particules 3D métalliques de tailles pouvant être microniques, ce qui crée en outre des rugosités nuisibles à la fabrication de dispositifs à base d'électrodes transparentes (créations de courts-circuits entre les couches...).

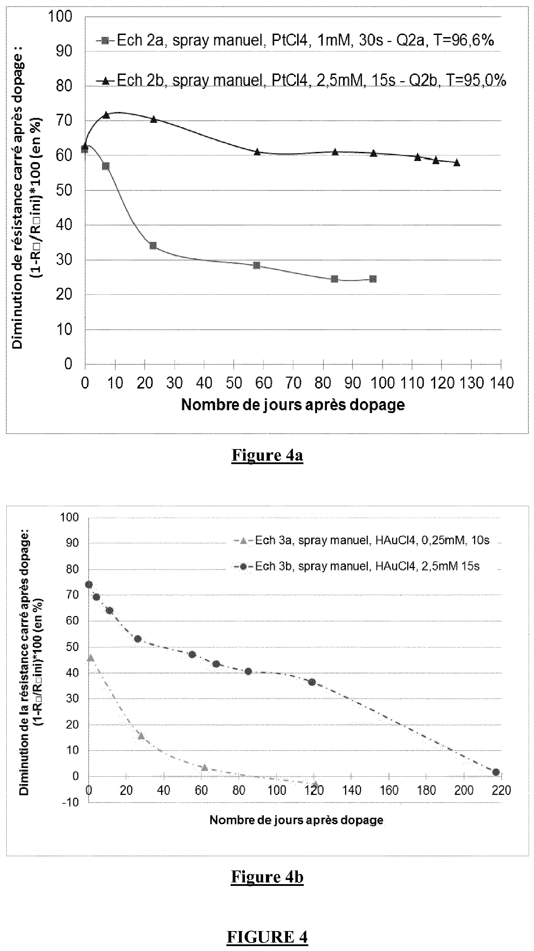

Avantageusement et contrairement à ce qui est classiquement observé pour d'autres solutions de sels métalliques et notamment d'Au, le dopage reste actif après un vieillissement temporel de l'échantillon. Cette efficacité est en particulier démontrée en figure 4. Une résistance carrée stabilisée ($R\square\infty$) inférieure à la résistance initiale avant dopage (RDini) y est conservée. Les sels ou complexes organométalliques de platine ou de palladium de degré d'oxydation +IV ou +II convenant à l'invention s'avèrent ainsi particulièrement avantageux comparativement à, par exemple, des sels d'Au. En effet, ils permettent d'assurer une efficacité de dopage stable dans le temps, contrairement à un sel d'Au qui se transforme progressivement en métal d'or et conduit à une perte de l'effet dopant.

Plus particulièrement, à titre de dopants conformes à l'invention, on peut notamment citer :

- les sels de platine ou de palladium de formules :

$$A_2MX_6, MX_4, A_2MX_4 \text{ et } MX_2$$

dans lesquelles :

- A est un atome d'hydrogène, un groupe $NH_4$, un atome de sodium, un atome de lithium ou un atome de potassium ;
- X est un atome de fluor, un atome de chlore, un atome de brome ou un atome d'iode ; et
- M est un atome de platine ou un atome de palladium de degré d'oxydation +IV ou +11.

    - les complexes organométalliques de platine ou de palladium tel que par exemple le $Pt(CH_3)_3I$; et
    - leurs mélanges.

Selon un mode de réalisation préféré, le dopant est un sel ou complexe organométallique de platine ou de palladium de degré d'oxydation +IV ou +II de formules telles que définies ci-dessus et est de préférence le sel de $PtCl_4$.

Comme exposé ci-dessus, le dopage de la couche de graphène à l'aide d'un ou plusieurs dopants conformes à l'invention, est réalisé par pulvérisation d'une solution liquide véhiculant ledit dopant. Dans la présente invention, cette solution liquide peut être nommée indifféremment « solution liquide de dopants » ou « solution de dopage ».

Pour des raisons évidentes, le milieu solvant composant la solution liquide de dopage est choisi de manière appropriée au regard de la nature du ou desdits dopants.

Conviennent tout particulièrement à la solution de dopage conforme à l'invention, des milieux solvants polaires qui permettent la dissolution des dopants inorganiques.

On peut citer notamment le nitrométhane, l'acétonitrile, l'acétone, la méthyléthylcétone, le diéthyl ether, le tetrahydrofurane, le dichlorométhane, le chloroforme et autres solvants chlorés, le benzonitrile, un solvant de type alcool, en particulier les monoalcools ayant de 1 à 5 atomes de carbone.

Selon un mode de réalisation préféré, le solvant est le nitrométhane.

Par ailleurs, des solvants à plus haut point d'ébullition comme la N-méthylpyrrolidone, la N-éthylpyrrolidone, le diméthylsulfoxide, l'éthylene glycol peuvent être utilisés et conduire à des performances similaires.

Ainsi, selon un mode de réalisation particulier, la solution liquide de dopant convenant à l'invention peut comprendre un solvant choisi parmi le nitrométhane, l'acétonitrile, l'acétone, la méthyléthylcétone, le diéthyl ether, le tetrahydrofurane, le dichlorométhane, le chloroforme et autres solvants chlorés, le benzonitrile, un solvant de type alcool, en particulier les monoalcools ayant de 1 à 5 atomes de carbone, la N-méthylpyrrolidone, la N-éthylpyrrolidone, le diméthylsulfoxide, l'éthylene glycol, et leurs mélanges, de préférence le nitrométhane.

Selon un mode de réalisation particulièrement préféré, la solution de dopage comprend du $PtCl_4$ en solution dans du nitrométhane.

D'une manière générale, la concentration de la solution de dopage convenant à l'invention est inférieure à 5 mM et préférence varie de 0,1 mM à 3 mM notamment dans le cas où le dopant considéré selon l'invention est le $PtCl_4$.

### c) Technique de dépôt par pulvérisation

Comme évoqué précédemment, dans un procédé selon l'invention, la solution de dopage est mise en contact, lors de l'étape (ii) sur au moins une zone voire toute la surface de la couche de graphène à doper, par pulvérisation de préférence au travers d'une buse.

En effet, les inventeurs ont constaté que contrairement aux autres techniques de dépôt et notamment la technique de dépôt par trempage, l'utilisation d'une technique de dépôt par pulvérisation permet d'augmenter sans limitation physique la quantité de dopants déposés à la surface du graphène.

En d'autres termes, la combinaison de la pulvérisation à titre de technique de dopage avec la nature chimique de dopant requise selon l'invention permet d'atteindre après stabilisation, une efficacité de dopage nettement meilleure par rapport aux techniques communes de dépôt des dopants.

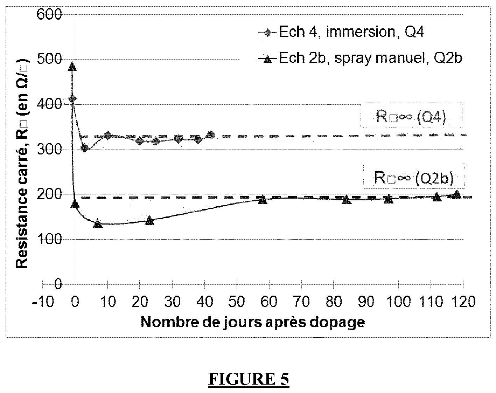

Ce résultat est notamment illustré en figure 5 qui montre que la technique de dépôt de $PtCl_4$ par pulvérisation manuelle conformément à l'invention permet avantageusement d'obtenir un graphène dopé dont la résistance carrée après dopage est très inférieure à celle obtenue pour un graphène dopé par une technique d'immersion.

Par ailleurs, la technique de dépôt par pulvérisation s'avère particulièrement efficace en termes de rendement (exprimé par le rapport pondéral de la quantité de dopants déposé à la surface du graphène sur la quantité de dopants dans la solution de dopage initiale), par rapport aux autres techniques de dépôt. Ainsi, contrairement aux techniques de dépôt par immersion ou « spin-coating », un rendement proche de 100 %, sans perte de métal précieux, est effectivement possible, ce qui constitue un avantage économique certain.

De préférence, la pulvérisation selon l'invention consiste à nébuliser en un brouillard de fines gouttelettes la solution liquide de dopant(s) sur au moins une zone voire toute la surface de la couche de graphène à doper.

La pulvérisation peut être réalisée en mode continu ou manuel.

Selon une première variante, les dopants peuvent être déposés à la surface du graphène par pulvérisation automatique. Cette pulvérisation peut être réalisée au moyen d'une buse soumise à des vibrations ultrasoniques, par exemple au moyen d'un équipement industriel commercialisé par la société SONO-TEK.

Selon une deuxième variante, les dopants peuvent être déposés à la surface du graphène par pulvérisation manuelle. Cette pulvérisation peut être réalisée au moyen d'une buse, notamment à l'aide d'un aérographe manuel AZTEK, par exemple de diamètre de 0,7 mm.

La couche de graphène destinée à être dopée est orientée face à la buse et généralement placée à une distance contrôlée par rapport à la sortie de la buse.

Comme détaillé ci-après, la buse peut être fixe ou mobile de même que l'entité substrat/couche de graphène à doper.

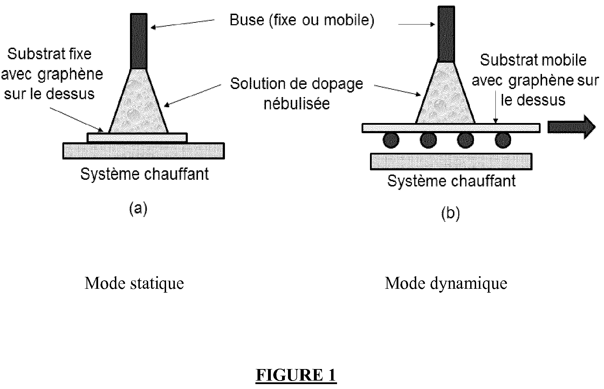

Le mode de réalisation où l'entité substrat/ couche de graphène à doper est fixe est en particulier illustré en figure 1 (a).

Le mode de réalisation où l'entité substrat/ couche de graphène à doper est mobile est illustré en figure 1 (b). Il est en particulier représentatif d'une technique de dopage au défilé selon un procédé « roll-to-roll ».

Dans cette variante de réalisation, la buse mobile utilisée est avantageusement une buse soumise à des vibrations ultrasoniques et dont la fréquence est d'autant plus élevée qu'il est recherché des gouttelettes de taille réduite.

Cette buse mobile peut se déplacer de telle sorte, par exemple selon un chemin croisé qui permet de favoriser l'homogénéité du dépôt de dopants. En effectuant plusieurs passages croisés, plusieurs dépôts consécutifs de dopants peuvent ainsi être superposés sur la même zone de la couche de graphène à doper afin de maximiser la quantité de dopants à la surface du graphène.

La durée de la pulvérisation au niveau de la zone traitée ou de toute la surface de la couche de graphène à doper, est donc variable. Comme évoqué précédemment, l'utilisation de différentes durées pour la pulvérisation permet, au même titre que l'utilisation de solutions de dopants à différentes concentrations, d'ajuster la quantité de dopants déposée au niveau de la couche de graphène à doper.

Selon un mode de réalisation particulier, le substrat supportant la couche de graphène peut être disposé à proximité immédiate voire au contact d'un système chauffant tel qu'un support chauffant ou une plaque chauffante portée à une température efficace pour l'élimination du milieu liquide véhiculant le ou les dopants conformes à l'invention.

Selon un autre mode de réalisation particulier, la solution liquide de dopant(s) peut être pulvérisée au travers d'un masque mécanique, par exemple un masque pochoir, de manière à ne doper qu'une zone de la couche de graphène à traiter.

Le masque, intercalé entre la buse et le substrat, est fixe et disposé légèrement au dessus de la couche de graphène à doper pour ne pas l'endommager. Il n'y a pas de contact direct entre la couche et le masque. Après dopage et stabilisation (temporelle ou en température), la couche de graphène dopé ainsi obtenue comporte des zones non dopées et des zones dopées délimitées selon le motif du masque. Il s'ensuit que les zones dopées sont dotées d'une conductivité électrique supérieure à celle des zones de graphène non dopées. La technique de dépôt des dopants par pulvérisation au travers d'un masque mécanique permet ainsi la localisation des dopants dans des zones définies à la surface du graphène.

Cette variabilité contrôlée de concentration en dopants sur une surface de graphène peut également être avantageusement ajustée *via* le contrôle de la pulvérisation en surface de la couche de graphène à travers la mobilité de la buse de pulvérisation et/ou de l'ensemble substrat/couche de graphène.

Selon un mode de réalisation préféré, l'ensemble substrat/couche de graphène est fixe et la buse est mobile.

Selon un autre mode de réalisation préféré, la buse est fixe et l'ensemble substrat/couche de graphène est mobile et défile selon un procédé « roll-to-roll ». Ce procédé peut être réalisé *via* un polymère adhésif de type « TRT » (« *Thermal Release Tape* » en anglais) comme décrit dans la publication Bae et al., Nature Technology, 5, 2010, 574 ou la demande US 2015/0162408 A1. Des bandes correspondant à différents taux de dopage peuvent donc ainsi être créées. Pour une vitesse de défilement donnée, la quantité de dopants déposée dans les différentes zones dépend des dimensions des ouvertures. Un procédé de type « roll-to-roll » permet de créer des zones de conductivité électrique distinctes par le choix de différents taux de dopage ou gradients de dopage sur l'ensemble substrat/couche de graphène qui défile.

Avantageusement, ce mode permet d'alterner zones dopées et zones non dopées, ou d'alterner des zones avec différentes efficacités de dopage.

## d) Ajustement de la quantité de dopants au niveau de la couche de graphène obtenue selon l'invention

Comme précisé ci-dessus, l'invention découle plus particulièrement de l'observation par les inventeurs qu'il s'avère possible, grâce aux choix de la technique de dépôt et de la nature de dopant, d'obtenir une couche de graphène dopé avec un excès de dopant et que cet excès en dopants, s'avère déterminant pour accéder à une efficacité de dopage avantageusement stabilisée au cours du vieillissement de la zone de graphène dopée.

De manière inattendue, le dopage d'un excès de dopants permet de conférer à la zone de la couche de graphène traitée, certes une valeur de résistance carré juste après dopage, $R\square D$, significativement diminuée par rapport à la valeur de résistance carré native $R\square ini$ mais surtout une valeur de résistance carré stabilisée $R\square\infty$, demeurant significativement inférieure à $R\square ini$. Ce gain en efficacité avantageusement stabilisé dans le temps est en outre obtenu pour un bon niveau de de transmittance.

Ainsi, et comme démontré dans les exemples qui suivent, la mise en oeuvre d'une technique de dépôt différente de la pulvérisation, telle que le trempage ne convient pas pour obtenir cet excès en dopant(s). Lors du trempage, la surface de la couche de graphène est en équilibre avec la solution de dopage et ne peut être augmentée arbitrairement. En effet, la solubilité du réactif de dopage dans le solvant n'est pas infinie et l'équilibre entre la solution et la surface du graphène limite la quantité de dopants adsorbée.

En revanche, la technique de dépôt par pulvérisation considérée selon l'invention permet d'accéder à un dopage en excès de dopant Q qui contre toute attente conditionne une valeur de résistance carrée $R\square\infty$, efficace.

Avantageusement, la valeur de $R\square\infty$ est d'autant plus faible et proche de la valeur de la résistance carrée juste après dopage $R\square D$, que la quantité de dopants en excès est élevée.

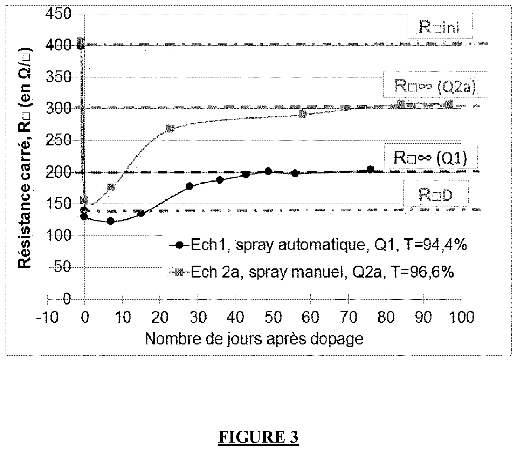

Ce phénomène est notamment illustré en figure 3, qui montre que la résistance carrée $R\square\infty$ d'une couche de graphène dopée par pulvérisation automatique de quatre couches de dopants successives avec une solution de $PtCl_4$ à 1 mM, dans le nitrométhane est de 200 ohm/carré contre 300 ohm/carré pour une couche de graphène dopée par pulvérisation manuelle pendant 30 s avec la même solution. Les transmittances respectives de 94,4% et 96,6%, mesurées à 550 nm juste après dopage pour les 2 conditions, témoignent d'une quantité en dopants supérieure pour la 1ère condition de dopage.

Plus préférentiellement, la quantité en dopant est avantageusement ajustée de manière à obtenir une résistance carrée stabilisée des zones dopées de la couche de graphène inférieure ou égale à 350 ohm/carré et une transmittance sur l'ensemble du spectre visible d'au moins 85 %.

De même, la quantité en dopant est avantageusement efficace pour procurer à ladite zone de graphène dopée une résistance carrée $R\square\infty$ dont la valeur correspond à une diminution d'au moins 10%, de préférence d'au moins 30% voire d'au moins 50% de la valeur de RDini, tout en conservant une valeur de transmittance supérieure à 85% sur l'ensemble du spectre du visible.

Le contrôle de l'ajustement de la quantité Q en dopant, peut avantageusement être réalisé par mesure de la transmittance de la zone de la couche de graphène traitée à une longueur d'onde donnée, notamment à 550 nm comme illustré dans la figure 2b.

Cette transmittance à 550 nm peut être mesurée au moyen d'un spectromètre UV-visible. Il est également possible de considérer une mesure en ligne au moyen d'un laser visible (HeNe, diode laser) ou proche infrarouge.

Ainsi, selon un mode de réalisation particulier, le procédé selon l'invention contrôle l'ajustement de la quantité en dopants Q au niveau de la zone de la couche de graphène traitée selon l'invention par mesure de la transmittance dans le domaine du visible de la couche de carbone de l'étape (ii).

Selon une variante préférée, ce contrôle est réalisé par comparaison de ladite mesure de transmittance obtenue à l'issue du dopage, de préférence le jour du dopage ou 1 à 2 jours après, à une mesure de transmittance de référence obtenue au préalable sur la couche de graphène de l'étape (i).

Cette transmittance est d'autant plus faible que la quantité de dopants est élevée comme illustré en figure 2b.

Ainsi la présente invention vise également la variante de procédé comprenant au moins les étapes consistant à :

(ia) mesurer la valeur de la transmittance $T_{ini}$ de la couche de graphène considérée en étape (i) préliminairement à la réalisation de l'étape (ii) ;
(iia) mesurer la valeur de la transmittance $T_D$ de ladite couche de graphène dopée juste après l'étape dopage (ii) ; et
(iib) apprécier la quantité de dopants, et donc en particulier l'efficacité du dopage, par comparaison de la transmittance $T_D$ à la transmittance $T_{ini}$, une valeur $T_D$ inférieure à une valeur $T_{ini}$ étant représentative d'un dopage effectif

Dans l'hypothèse où aucune différence significative n'est observée entre les valeurs $T_D$ et $T_{ini}$, le dopage de l'étape (ii) est poursuivi ou reproduit avec le cas échéant un ajustement des conditions de pulvérisation et/ou de la concentration en dopants de la solution liquide de dopants.

De manière avantageuse, la quantité de dopant et les conditions de dépôt peuvent être ainsi ajustées et optimisées en fonction de la valeur de la transmittance optique.

Avantageusement, le procédé selon l'invention comprend en outre consécutivement à l'étape de dopage (ii) une étape (iii) visant à stabiliser les dopants au niveau de la couche de graphène.

Cette étape (iii) est une étape de stabilisation temporelle, qui peut être éventuellement accélérée par voie thermique.

Dans cette variante de réalisation, le procédé selon l'invention peut avantageusement comprendre une étape (iiia) consistant à mesurer la valeur de la transmittance $T_\infty$ de ladite couche de graphène dopée et stabilisée, et consécutivement, une étape (iiib) consistant à apprécier l'efficacité du dopage par comparaison de la transmittance $T_\infty$ à la transmittance $T_{ini}$, une valeur $T_\infty$ inférieure à une valeur $T_{ini}$ étant représentative d'un dopage effectif conservé après stabilisation.

Avantageusement, le procédé selon l'invention peut comprendre en outre consécutivement à l'étape de dopage (ii), et si présente de l'étape (iii) de stabilisation telle que définie précédemment, au moins une étape (iv) consistant à transférer, par voie sèche ou par voie humide, une couche de graphène de préférence transparente, en surface de la couche de graphène dopé obtenue à l'issue de l'étape (ii).

Cette seconde variante de réalisation constitue une alternative particulièrement intéressante à la stabilisation temporelle ou par voie thermique précitée. En effet, il est observé une meilleure conductivité électrique de la monocouche de graphène dopée correspondante. Ceci est dû principalement à la conservation des dopants par encapsulation par la couche de graphène supérieure transférée.

Bien entendu, cette nouvelle couche de graphène peut à son tour être mise en oeuvre dans un procédé conforme à l'invention, à titre de la couche de graphène à doper considérée en étape (i).

## II- COUCHE DE GRAPHENE DOPE OBTENU SELON L'INVENTION ET SES APPLICATIONS

Comme énoncé ci-dessus, la couche de graphène dopée selon le procédé de l'invention est caractérisée par une valeur de résistance carrée R☐∞.

La résistance carrée R☐∞ de la couche de graphène dopé selon l'invention est significativement inférieure à la résistance carrée de la zone de graphène non dopée, à savoir R☐ini, notamment d'au moins 10%, de préférence d'au moins 30% voire d'au moins 50% par rapport à la valeur de R☐ini.

La valeur de cette résistance carrée stabilisée R☐∞ peut être égale à la valeur de la résistance R☐D. Généralement, elle est comprise entre les valeurs R☐ini, et R☐D.

Une résistance carrée d'une couche de graphène dopée considérée selon l'invention peut être caractérisée comme étant conforme à la résistance carrée stabilisée R☐∞ requise selon l'invention à partir du moment où il n'est constaté aucune variation ou augmentation de plus de 8% de sa valeur au cours du temps.

Des tests peuvent le cas échéant être mis en oeuvre pour la caractériser. Par exemple un test de de « vieillissement » sur une durée pouvant aller jusqu'à 50 jours voire plus ou même moins, à température ambiante (20 °C +/- 3 °C) et pression atmosphérique, à compter du dopage. Un autre test, plus rapide en termes de durée, peut consister à imposer un recuit à une température comprise entre 100 °C et 200°C juste après dopage de la couche de graphène dopé. L'alternative de stabilisation en température permet d'induire un « vieillissement » accéléré, pour atteindre plus rapidement une valeur de R☐ stable dans le temps et figurée par R☐∞. Bien entendu, cette température est fonction du sel utilisé et de la quantité de dopants à la surface du graphène. Ces ajustements de mesure relèvent clairement des compétences de l'homme de l'art. Typiquement, elle est supérieure ou égale à la température utilisée lors de l'étape de pulvérisation du dopant et inférieure à 200°C.

Selon un autre aspect, la présente invention concerne un matériau comprenant au moins une couche de graphène dopé obtenu par le procédé tel que défini précédemment. Un tel matériau possède des propriétés intéressantes en termes de conductivité électrique et de transparence.

Un graphène dopé *via* le procédé selon l'invention peut être utilisé pour de nombreuses applications : écrans ultrafins et flexibles, écrans tactiles, batteries, cellules solaires, électronique, opto-électronique, spintronique, biocapteurs, traitement de la pollution, etc.

En outre, ce graphène dopé offre une alternative intéressante pour la réalisation d'électrodes transparentes et conductrices qui sont comprises dans des dispositifs de visualisation (afficheurs, écrans plats, diodes électroluminescentes organiques (OLED)) ou des dispositifs photovoltaïques.

Bien entendu, l'invention n'est pas limitée aux modes de réalisations décrits ci-dessus.

L'invention va maintenant être décrite au moyen des exemples et figures suivants, donnés à titre illustratif et non limitatif de l'invention.

## FIGURES

**Figure 1** : Illustration schématique d'un dépôt par pulvérisation sur un substrat fixe (a) (mode statique), ou sur un substrat mobile (b) (mode dynamique) pour un procédé de dopage au défilé de type « roll-to-roll ».

**Figures 2** : Efficacité comparée du dopage d'une monocouche de graphène au moyen d'une solution de $PtCl_4$ diluée dans le nitrométhane à une concentration de 1 mM et réalisé en superposant une, deux puis quatre couches de dopants à la surface du graphène.

La figure 2a représente la résistance carrée R☐D mesurée juste après dopage, en fonction du nombre de couches de dopants, à savoir une, deux puis quatre, pour une quantité croissante de dopants respectivement Q, 2Q puis 4Q.

La figure 2b représente les valeurs de transmittance associées mesurées à 550 nm juste après dopage.

**Figure 3** : Evolution temporelle de la résistance carrée R☐∞ d'un graphène monocouche après dopage par une solution de $PtCl_4$ diluée dans du nitrométhane (1 mM) pour deux quantités différentes de dopants (Q) (exemples 1 et 2).

**Figures 4** : Efficacité comparée du dopage d'une monocouche de graphène au moyen d'une pulvérisation manuelle pour deux complexes métalliques différents, $PtCl_4$ convenant à l'invention ou $HAuCl_4$ non conforme à l'invention.

La figure 4a illustre les échantillons 2a et 2b de l'exemple 2 dopés par des solutions de $PtCl_4$ pour des concentrations respectives de 1 mM et 2,5 mM.

La figure 4b illustre les échantillons 3a et 3b dopés par des solutions de $HAuCl_4$ pour des concentrations respectives de 0,25 mM et 2,5 mM.

**Figure 5** : Influence de la technique de dépôt sur l'évolution temporelle de la résistance carrée d'un graphène monocouche après dopage par une solution de $PtCl_4$ diluée dans du nitrométhane (2,5 mM).

Il convient de noter que, pour des raisons de clarté, les différents éléments visibles sur les figures sont représentés en échelle libre, les dimensions réelles des différentes parties n'étant pas respectées.

## EXEMPLES

Les abréviations suivantes ont été utilisées :

| | |
|---|---|
| R□ : | Résistance carrée |
| R□ini : | Résistance carrée initiale, c'est-à-dire résistance carrée avant dopage |
| R□D : | Résistance carrée D, c'est-à-dire résistance carrée juste après dopage |
| R□∞ : | Résistance carrée ∞, c'est-à-dire résistance carrée après dopage et après stabilisation |
| Ω/□ : | Ohm/carré |
| T : | Transmittance à 550 nm |
| Tini: | Transmittance à 550 nm avant dopage, soit juste après le transfert de la deuxième couche de graphène selon le cas mentionné |
| $T_D$ : | Transmittance à 550 nm juste après dopage |
| T∞ : | Transmittance à 550 nm mesurée après dopage et stabilisation |
| Ech : | Echantillon |
| G : | Monocouche de graphène |
| GD : | Monocouche de graphène dopée |
| GDG : | Monocouche de graphène dopée recouverte d'une monocouche de graphène |
| GDGDG : | Monocouche de graphène dopée recouverte d'une monocouche de graphène dopée, elle-même revêtue d'une monocouche de graphène |

Méthodes de mesure

La résistance carrée de la couche de graphène est mesurée sur l'ensemble de la surface de l'échantillon selon une technique de mesure 4 pointes par effet Hall avec une géométrie de type Van der Pauw, à l'aide d'un équipement Ecopia HMS-3000, pour un courant compris entre -100 et +100 μA

La transmittance, T, est mesurée à 550 nm au moyen d'un spectromètre UV-visible-proche infra-rouge de type Agilent cary 5000. T représente le rapport des transmittances entre l'échantillon à caractériser et constitué d'un substrat transparent recouvert d'une ou plusieurs mono-couches de graphène dopées ou non dopées et un échantillon de référence correspondant à un substrat nu de nature identique.

**Exemple 1** : **Graphène mono-couche dopé au moyen d'une pulvérisation automatique type SONO-TEK (substrat fixe et buse mobile)**

**(i) Echantillon 1 :**

Le substrat est un substrat en verre dont les dimensions sont $2,5 \times 2,5$ cm$^2$.

Le graphène est un graphène mono-couche, élaboré par CVD (*Chemical Vapor Déposition*) sur feuillard de cuivre et transféré sur le substrat en verre selon une technique de transfert humide conventionnelle classiquement décrite dans la littérature *via* une couche de PMMA (poly(methyl methacrylate) sacrificielle support, une gravure humide du cuivre, et la récupération en surface du substrat cible (verre) de l'empilement graphène/PMMA flottant à la surface du bain d'eau de rinçage selon le procédé décrit dans la publication Suk et al., ACS Nano, 5, 2011, 6916.

**(ii) Solution de dopage :**

La solution de dopage est formée de sel de $PtCl_4$ solide dissous dans le nitrométhane. La concentration de la solution est de 1 mM.

**(iii) Conditions de dépôt des dopants :**

Les dopants sont déposés à la surface du graphène par pulvérisation (ou « spray ») automatique au moyen d'une buse soumise à des vibrations ultrasoniques *via* un équipement industriel commercialisé par la société SONO-TEK. La buse placée au-dessus du substrat, à une distance de 10 cm, se déplace au-dessus de l'échantillon à doper, qui est fixe et posé sur un support chauffant à 110 °C. La pulvérisation est créée par la buse au moyen d'un système ultrason, à la fréquence de 48 kHz. La solution est injectée dans la buse à la vitesse de 0,75 mL/min. La buse se déplace au-dessus de l'échantillon en balayant un chemin au pas de 5 mm, correspondant à un passage croisé, ceci pour favoriser l'homogénéité du dépôt. Plusieurs « couches » de dopants (une, deux puis quatre couches) sont superposées sur le même échantillon pour maximiser la quantité de dopants (respectivement nommée Q, 2Q et 4Q) à la surface du graphène, en effectuant plusieurs passages croisés sur le même échantillon. Par exemple, quatre « couches » de dopants correspondent à quatre passages croisés de la buse.

Les performances électriques et optiques de cet échantillon avant et après dopage (juste après dopage et le cas échéant après stabilisation temporelle) selon le nombre de passages croisés, à savoir un, deux et quatre passages, de la buse au-dessus de l'échantillon sont présentées dans les tableaux 1a et 1b et sur les figures 2a, 2b et 3.

**Tableau 1a**

| Avant dopage | |
| --- | --- |
| R□ini (en $\Omega$/□) | Transmittance à 550 nm, Tini (en %) |
| 398 | 97,5 |

**Tableau 1b**

| Nombre de passages croisés ou de « couches » de dopants / Quantité de dopants | Juste après dopage | | |
| --- | --- | --- | --- |
| | R□D (en $\Omega$/□) | Efficacité du dopage ou diminution de R□ (1-R□D/R□ini)x100 (en %) | Transmittance à 550 nm, $T_D$ (en %) |
| 1/Q | 156 | 60,8 | 97,4 |
| 2/2Q | 140 | 64,8 | 97,2 |
| 4 / 4Q | 129 | 67,6 | 94,4 |

Les résultats montrent que la superposition de quatre « couches » de dopants satisfait la notion de dopants en « excès » : en effet, cette condition n'induit pas de diminution significative de R□D par rapport à la superposition de 2 couches de dopants. De plus, cette quantité de dopants s'avère compatible avec une valeur de transmittance satisfaisante (valeur de 94,4 %).

Un test de vieillissement, a en outre été réalisé sur la couche de carboné dopé ayant subi 4 pulvérisations successives.

Ce test de vieillissement consiste à conserver juste après dopage, l'échantillon dopé pendant plus de 60 jours à température ambiante (20 °C +/- 3 °C) et pression atmosphérique

Après stabilisation temporelle, la R□∞ possède une valeur d'environ 200 $\Omega$/□, ce qui correspond à une diminution de 50 % de la résistance carrée avant dopage RDini et donc à un gain significatif de conductivité.

**Exemple 2: Graphène mono-couche dopé au moyen d'une pulvérisation manuelle (substrat et buse fixes)**

**(i) Echantillons 2a et 2b :**

Les échantillons sont identiques à celui préparé en exemple 1.

**(ii) Solutions de dopage :**

Deux solutions de dopage dont la concentration en sel de $PtCl_4$ solide dissous dans le nitrométhane est respectivement de 1 mM et de 2,5 mM sont préparées.

**(iii) Conditions de dépôt des dopants :**

Chacune des solutions est nébulisée *via* une buse à l'aide d'un aérographe manuel AZTEK, de diamètre 0,7 mm. Il est fixe, et maintenu au-dessus de l'échantillon à une distance de 20 cm. Le substrat est fixe, centré à la perpendiculaire de la sortie de la buse et posé sur une plaque chauffante à 110 °C.

**(iv) Durée de l'exposition à la nébulisation :**

- **L'échantillon 2a** est exposé 30 secondes à la solution de dopants dont la concentration est de 1 mM.
- **L'échantillon 2b** est exposé 15 secondes à la solution de dopants dont la concentration est de 2,5 mM.

L'utilisation de solution de différentes concentrations et l'utilisation de différentes durées d'exposition à la nébulisation permet de faire varier la quantité de dopants déposée à la surface du graphène.

Les performances électriques et optiques des échantillons 2a et 2b, avant et après dopage (juste après dopage et après stabilisation temporelle de plus de 60 jours, sont présentées dans les tableaux 2a et 2b et sur les figures 3 et 4a.

**Tableau 2a**

|  | Avant dopage | |
|---|---|---|
|  | R□ini (en $\Omega$/□) | Transmittance à 550 nm, Tini (en %) |
| Ech 2a | 406 | 97,3 |
| Ech 2b | 485 | 97,4 |

**Tableau 2b**

| Conditions de dopage | Juste après dopage | | | Après stabilisation temporelle | |
|---|---|---|---|---|---|
|  | RD D (en $\Omega$/□ ) | Efficacité du dopage (1-R□D/R□ini)x100 (en %) | Transmittan ce à 550 nm, $T_D$ (en %) | R□$\infty$ (en $\Omega$/□) | Efficacité du dopage (1-R□$\infty$/R□ini)x100 (en %) |
| **Ech 2a :** PtCl$_4$, 1 mM, 30 s | 156 | 61,6 | 96,6 | 300 | 26 |
| **Ech 2b :** PtCl$_4$, 2,5 mM, 15 s | 181 | 62,3 | 95,0 | 195 | 60 |

L'utilisation de la solution de dopage de PtCl$_4$ la plus concentrée, à savoir 2,5 mM permet d'obtenir une valeur de R□$\infty$ après stabilisation temporelle d'environ 195 $\Omega$/□, contre une valeur de 300 pour la valeur de R□$\infty$ obtenue avec l'échantillon 1 dopé avec une quantité moindre en PtCl$_4$, comme en témoignent les valeurs respectives de transmittances mesurées juste après dopage.

Il est à noter qu'en revanche les R□D des deux échantillons sont comparables.

Ces résultats révèlent donc bien l'incidence bénéfique de la présence d'un excès de dopants sur la R□$\infty$ d'une couche de graphène ainsi dopé. L'efficacité du dopage n'est en outre pas obtenu au détriment de la transmittance qui demeure satisfaisante puisque de 95%.

**Exemple 3** : **Réalisation d'un empilement bi-couches de graphène avec intercalation des dopants (graphène/dopants/graphène : GDG), après stabilisation des dopants de la 1ère couche et transfert de la 2ème couche selon un procédé en voie sèche**

Une première couche de graphène élaborée sur feuillard de cuivre puis transférée sur un substrat en verre est dopée par une solution de PtCl$_4$ selon l'exemple 1 et plus particulièrement selon les modalités de l'échantillon 1.

La stabilisation des dopants est obtenue soit après une durée minimum d'environ 60 jours (stabilisation temporelle), soit après recuisson de l'échantillon juste après dopage à 100 °C pendant 1 h sous vide et attente d'une durée minimum de 30 jours (stabilisation accélérée en température).

L'étape de transfert de la deuxième couche de graphène après la stabilisation des dopants est réalisée cette fois selon un procédé en voie sèche, tels que ceux classiquement décrits dans la littérature selon par exemple la publication Suk et al., ACS Nano, 5, 2011, 6916.

Le transfert s'effectue *via* un polymère sacrificiel support placé ou déposé à la surface du graphène et la gravure du cuivre s'effectue en solution. En revanche, le transfert de l'empilement graphène/polymère support sur le substrat cible (substrat de verre avec la première couche de graphène dopée) est effectué en voie sèche, à l'aide d'une couche de PMMA recouverte d'un cadre PDMS (poly(diméthylsiloxane) comme décrit dans la publication Suk et al., ACS Nano, 5, 2011, 6916.

Le tableau 3 rassemble un exemple de performances électriques et optiques des couches au cours des différentes étapes de cet exemple.

**Tableau3**

| | | RD | R□(∞) Après stabilisation temporelle | Transmittance à 550 nm | Transmittanc e à 550 nm après stabilisation temporelle |
|---|---|---|---|---|---|
| Graphèn e mono-couche | **Ech 1 : G** Avant dopage | R□ini(1) =398Ω/ □ | | Tini(1)=97,5 % | Non mesurée |
| | **GD** Dopage : pulvérisatio n automatique , PtCl$_4$ 1mM, 4 couches de dopants | R□D=129Ω /□ | R□∞=200Ω/ □ | T$_D$=94,4% | T∞=95,6% |
| Système bi-couches | **GDG** Après transfert de la 2ème couche de graphène | R□ini(2) =136Ω/ □ | | Tini(2)=93,2 % | Non mesurée |

On constate que l'empilement bicouche GDG de graphène avec intercalation des dopants permet d'atteindre une transmittance de 93,2 % et une RD de 136 Ω/□ comparativement à la monocouche de graphène dopée et stabilisée correspondante, GD, qui permet d'accéder à une transmittance de 95,6 % et une RD de 200 Ω/□. La diminution de transmittance et de résistance carrée observées après ajout de la couche supérieure de graphène sont cohérentes avec la conservation des dopants lors de l'étape de transfert de la 2ème couche.

L'ajout de la 2ème couche de graphène permet encore d'améliorer la conductivité électrique de l'empilement, par rapport à une mono-couche de graphène dopée et stabilisée, tout en conservant une transmittance acceptable.

**Exemple 4 : Efficacité du dopage, comparaison entre des solutions de PtCl$_4$ dans le nitrométhane convenant à l'invention et des solutions de HAuCl$_4$ dans le nitrométhane non conformes à l'invention**

Les figures 4a et 4b comparent l'évolution temporelle de l'efficacité de dopages par pulvérisation manuelle réalisés respectivement au moyen de

a) complexes convenant à l'invention (dopage par des solutions de PtCl$_4$ dans le nitrométhane pour des concentrations respectives de 1 mM et 2,5 mM, voir exemple 2) et
b) de sels d'Au non conformes à l'invention (dopage par des solutions de HAuCl$_4$ dans le nitrométhane pour des concentrations respectives de 0,25 mM et 2,5 mM et des durées respectives de 10s et 15s).

L'efficacité du dopage peut être exprimée *via* un pourcentage représentatif de la diminution de la résistance carrée induite par le dopage par rapport à la valeur de la résistance carrée avant dopage : (1- R□/R□]ini) × 100.
De l'examen des figures 4a et 4b, il ressort que :

Avec les sels d'Au comme illustré en figure 4b, selon les conditions de dépôts, les dopants sont progressivement perdus au cours du temps. Au final, après un temps caractéristique (typiquement compris entre 90 et 220 jours), la résistance carrée du graphène revient à une valeur égale ou même supérieure à la valeur initiale non dopée. En d'autres termes, cela traduit une efficacité de dopage nulle.

La nature du dopant utilisé et son degré d'oxydation à la surface du graphène peuvent être analysés par spectroscopie XPS (« *X-Ray photoelectron spectrometry* » en anglais).
Pour un dopage selon l'invention, après vieillissement temporel de l'échantillon dopé, la conservation d'espèces au degré d'oxydation +IV ou +II, non intégralement transformées en métal (degré d'oxydation 0), est représentative de la conservation de l'effet dopant par transfert de charge au cours du temps.

Au contraire, un sel d'Au à la surface du graphène se transforme progressivement à température ambiante en métal d'or, ce qui peut être associé à la perte totale de l'effet dopant.

**Revendications**

1. Procédé utile pour préparer une couche de graphène transparente et de conductivité électrique améliorée et stabilisée, ledit procédé comprenant au moins les étapes consistant à :

   (i) disposer d'au moins une couche de graphène transparente et possédant une résistance carrée, R☐ini,
   (ii) doper au moins une zone de ladite couche de graphène pour former une zone de graphène dopée ayant une résistance carrée stabilisée, R☐∞, de valeur inférieure à R☐ini.

   **caractérisé en ce que** l'étape (ii) est réalisée par pulvérisation, en surface d'au moins ladite zone de ladite couche de graphène (i), d'au moins un dopant choisi parmi les sels et complexes organométalliques de platine ou de palladium de degré d'oxydation +IV ou +11.

2. Procédé selon la revendication précédente, **caractérisé en ce que** la valeur de la résistance carrée stabilisée, R☐∞, est comprise entre la valeur RDini et la valeur de résistance carrée obtenue juste après dopage R☐D.

3. Procédé selon l'une quelconque des revendications précédentes, **caractérisé en ce que** la couche de graphène à doper possède une valeur de transmittance supérieure ou égale à 85%, avantageusement supérieure ou égale à 90% et de préférence supérieure à 95% sur l'ensemble du spectre du visible.

4. Procédé selon l'une quelconque des revendications précédentes, **caractérisé en ce que** la couche de graphène est un graphène monocouche élaboré par une technique de dépôt chimique en phase vapeur (CVD) et dont la valeur de transmittance est supérieure à 95%.

5. Procédé selon l'une quelconque des revendications précédentes, **caractérisé en ce que** la couche de graphène de l'étape (i) est supportée par un substrat, notamment un substrat transparent ou translucide dans le domaine du visible ou de l'infra-rouge et de préférence choisi parmi le verre, polyéthylène téréphtalate, polycarbonate, polyimide, polyéthylène naphtalate, polydiméthylsiloxane, polystyrène, polyether sulfone, du silicium recouvert d'une couche de nitrure ou d'une couche d'oxyde telle que SiOx, ou $Al_2Ox$, et de préférence est choisi parmi du verre et du polyéthylène téréphtalate.

6. Procédé selon la revendication 5, **caractérisé en ce que** ladite couche de graphène de l'étape (i) est directement au contact dudit substrat.

7. Procédé selon la revendication 5, **caractérisé en ce que** ladite couche de graphène de l'étape (i) est au contact d'une couche de graphène dopée qui est intercalée entre ledit substrat et ladite couche de graphène à doper.

8. Procédé selon la revendication précédente, **caractérisé en ce que** ladite couche de graphène dopée disposée au contact de la couche de graphène a elle-même été obtenue par dopage d'une couche de graphène selon un procédé tel que défini selon l'une quelconque des revendications précédentes.

9. Procédé selon l'une quelconque des revendications précédentes, **caractérisé en ce que** le dopant est choisi parmi :

   - les sels de platine ou de palladium de formules :

   $$A_2MX_6, MX_4, A_2MX_4 \text{ et } MX_2$$

   dans lesquelles :

   - A est un atome d'hydrogène, un groupe $NH_4$, un atome de sodium, un atome de lithium ou un atome de potassium ;
   - X est un atome de fluor, un atome de chlore, un atome de brome ou un atome d'iode ; et
   - M est un atome de platine ou un atome de palladium de degré d'oxydation +IV ou +II, et en particulier parmi les sels de $PtCl_4$, $H_2PtCl_6$, $PtCl_2$, $H_2PdCl_6$, $PdCl_2$, et leurs mélanges et est de préférence le $PtCl_4$.

**10.** Procédé selon la revendication précédente, caractérisé en ce le dopant est sous forme d'une solution de $PtCl_4$ à une concentration inférieure à 5 mM et de préférence qui varie de 0,1 mM à 3 mM.

**11.** Procédé selon l'une quelconque des revendications précédentes, **caractérisé en ce que** l'opération de pulvérisation au niveau de la couche de graphène peut être réalisée en une fois ou répétée une à plusieurs fois.

**12.** Procédé selon l'une quelconque des revendications 1 à 9, **caractérisé en ce que** le dopant est un complexe organométallique de platine ou de palladium de degré d'oxydation +II ou +IV, et de préférence le $Pt(CH_3)_3I$.

**13.** Procédé selon l'une quelconque des revendications précédentes, **caractérisé en ce que** l'étape (ii) est réalisée en mode dynamique selon une technique de dopage au défilé et en particulier de type « roll-to-roll ».

**14.** Procédé selon l'une quelconque des revendications 5 à 13, **caractérisé en ce que** le substrat supportant la couche de graphène traitée en étape (ii), est chauffé à une température propice à l'élimination du milieu solvant de la solution liquide de dopant.

**15.** Procédé selon l'une quelconque des revendications précédentes, **caractérisé en ce qu'**il comprend en outre les étapes supplémentaires consistant à :

(ia) mesurer, par exemple par une mesure en ligne au moyen d'un laser visible ou proche infrarouge, la valeur de la transmittance $T_{ini}$ de la couche de graphène considérée en étape (i) préliminairement à la réalisation de l'étape (ii) ;
(iia) mesurer, par exemple par une mesure en ligne au moyen d'un laser visible ou proche infrarouge, la valeur de la transmittance $T_D$ de ladite couche de graphène dopée juste après l'étape dopage (ii) ; et
(iib) apprécier la quantité de dopants par comparaison de la transmittance $T_D$ à la transmittance $T_{ini}$, une valeur $T_D$ inférieure à une valeur $T_{ini}$ étant représentative d'un dopage effectif.

**16.** Procédé selon l'une quelconque des revendications précédentes, **caractérisé en ce qu'**il comprend en outre consécutivement à l'étape de dopage (ii), et si présente de l'étape (iib), une étape (iii) de stabilisation des sels ou complexes organométalliques de platine ou de palladium de degré d'oxydation +IV ou +II au niveau de la couche de graphène dopée.

**17.** Procédé selon l'une quelconque des revendications précédentes, **caractérisé en ce qu'**il comprend en outre consécutivement à l'étape de dopage (ii), et si présente de l'étape (iii) de stabilisation selon la revendication 16, au moins une étape (iv) consistant à transférer, de préférence par voie sèche, une couche de graphène non dopée en surface de la couche de graphène dopé obtenue à l'issue de l'étape (ii).

**18.** Procédé selon l'une quelconque des revendications précédentes, **caractérisé en ce que** le dopant est le $PtCl_4$, et la zone de la couche de graphène dopée et stabilisée possède, une résistance carrée stabilisée, $R\square\infty$ inférieure ou égale à 350 $\Omega/\square$ et de préférence inférieure ou égale à 300 $\Omega/\square$ voire inférieure ou égale à 200 $\Omega/\square$ et une transmittance T supérieure à 85% sur l'ensemble du spectre du visible.

**19.** Matériau comprenant au moins une couche de graphène dopé obtenu par le procédé tel que défini selon l'une quelconque des revendications 1 à 18.

**20.** Utilisation d'un graphène dopé obtenu par le procédé tel que défini selon l'une quelconque des revendications 1 à 18 ou d'un matériau tel que défini en revendication 19 pour fabriquer des écrans ultrafins et flexibles, des écrans tactiles, des batteries, des cellules solaires, des biocapteurs, des dispositifs électroniques ou opto-électroniques, des dispositifs spintroniques, des électrodes transparentes conductrices destinées à être incorporées dans des dispositifs de visualisation tel que des afficheurs, des écrans d'affichage, des écrans plats, et des diodes électroluminescentes organiques (OLED) ou dans des dispositifs photovoltaïques.

**21.** Dispositif comprenant un graphène dopé obtenu par le procédé tel que défini selon l'une quelconque des revendications 1 à 18 ou un matériau tel que défini en revendication 19.

**22.** Dispositif selon la revendication précédente, choisi parmi des écrans ultrafins et flexibles, des écrans tactiles, des batteries, des cellules solaires, des biocapteurs, des dispositifs électroniques ou opto-électroniques, des dispositifs spintroniques, des électrodes transparentes conductrices, des dispositifs de visualisation tel que des afficheurs, des écrans d'affichage, des écrans plats, et des diodes électroluminescentes organiques (OLED), et des dispositifs photovoltaïques.

Mode statique      Mode dynamique

**FIGURE 1**

**Figure 2a**

**Figure 2b**

**FIGURE 2**

**FIGURE 3**

**Figure 4a**

**Figure 4b**

**FIGURE 4**

**FIGURE 5**

Europäisches
Patentamt

European
Patent Office

Office européen
des brevets

**RAPPORT PARTIEL
DE RECHERCHE EUROPEENNE**

selon la règle 62a et/ou 63 de la Convention sur le brevet
européen. Ce rapport est considéré, aux fins de la procédure
ultérieure, comme le rapport de la recherche européenne.

Numéro de la demande

EP 17 20 2863

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | MYOUNG JUN CHA ET AL: "MeV Electron-Beam Induced Clusterization of Platinum Chloride on Graphene for Transparent Conductive Electrodes", ADVANCED MATERIALS RESEARCH, vol. 677, 25 mars 2013 (2013-03-25), pages 25-30, XP055385604, DOI: 10.4028/www.scientific.net/AMR.677.25 * le document en entier * ----- | 1-22 | INV.<br>H01L29/16<br>H01M4/62<br>C01B32/194<br>C23C16/26<br>H01B1/04<br>H01B5/14<br>H01B13/00 |
| X | KI CHANG KWON ET AL: "Role of ionic chlorine in the thermal degradation of metal chloride-doped graphene sheets", JOURNAL OF MATERIALS CHEMISTRY C: MATERIALS FOR OPTICAL AND ELECTRONIC DEVICES, vol. 1, no. 2, 1 janvier 2013 (2013-01-01) , pages 253-259, XP055385611, UK ISSN: 2050-7526, DOI: 10.1039/C2TC00008C * abrégé * * alinéa ["dopingandannealingprocedure"] * * figures 1,2,7 * ----- -/-- | 1-22 | |

| | | | DOMAINES TECHNIQUES RECHERCHES (IPC) |
|---|---|---|---|
| | | | C01B<br>H01L<br>H01M |

## RECHERCHE INCOMPLETE

La division de la recherche estime que la présente demande de brevet, ou une ou plusieurs revendications, ne sont pas conformes aux dispositions de la CBE de façon que seulement une recherche partielle a été établie.

Revendications ayant fait l'objet d'une recherche complète:

Revendications ayant fait l'objet d'une recherche incomplète:

Revendications n'ayant pas fait l'objet d'une recherche:

Raison pour la limitation de la recherche:

voir feuille supplémentaire C

| Lieu de la recherche | Date d'achèvement de la recherche | Examinateur |
|---|---|---|
| La Haye | 13 juillet 2018 | Mertins, Frédéric |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

page 1 de 2

Europäisches
Patentamt

European
Patent Office

Office européen
des brevets

**RAPPORT PARTIEL
DE RECHERCHE EUROPEENNE**

Numero de la demande

EP 17 20 2863

| | DOCUMENTS CONSIDERES COMME PERTINENTS | | CLASSEMENT DE LA DEMANDE (IPC) |
|---|---|---|---|
| Catégorie | Citation du document avec indication, en cas de besoin, des parties pertinentes | Revendication concernée | |
| X | US 2011/127471 A1 (SHIN HYEON-JIN [KR] ET AL) 2 juin 2011 (2011-06-02)<br>* abrégé *<br>* alinéas [0003], [0015], [0076] *<br>* revendications 1-15 *<br>----- | 1-22 | |
| X | KR 2013 0099535 A (UNIV CHUNG ANG IND [KR]) 6 septembre 2013 (2013-09-06)<br>* abrégé *<br>* alinéas [0027], [0028] *<br>* figures 2,3,4,8,9 *<br>* revendications 1-12 *<br>----- | 1-22 | |
| X | KR 2014 0143533 A (LG ELECTRONICS INC [KR]) 17 décembre 2014 (2014-12-17)<br>* abrégé *<br>* alinéa [0056] - alinéa [0063] *<br>----- | 1 | DOMAINES TECHNIQUES RECHERCHES (IPC) |
| X | WO 2014/065534 A1 (SAMSUNG ELECTRONICS CO LTD [KR]) 1 mai 2014 (2014-05-01)<br>* abrégé *<br>* revendications 1-20 *<br>----- | 1 | |

EPO FORM 1503 03.82 (P04C11)

page 2 de 2

Europäisches
Patentamt

European
Patent Office

Office européen
des brevets

**RECHERCHE INCOMPLETE**
**FEUILLE SUPPLEMENTAIRE C**

Numéro de la demande

EP 17 20 2863

Revendications ayant fait l'objet de recherches incomplètes:
        1-22

Raison pour la limitation de la recherche:

La présente revendication 1 couvre un nombre extrêmement important de procédés potentiels. Cependant, il n'est possible de trouver un fondement et un exposé au sens des articles 84 et 83 CBE que pour un nombre très limité des procédés revendiqués (cf. la description de la présente application, pages 23-30, exemples 1-4).
La demande n'est pas conforme aux dispositions de fond au point qu'une recherche significative n'a pu être effectuée au regard de l'ensemble de l'objet revendiqué (règle 63 CBE et Directives B-VIII, 3).
L'étendue de la recherche a par conséquent été limitée.
La recherche portant sur la revendication 1 a été circonscrite aux procédés revendiqués qui semblent avoir un fondement, et à une généralisation de leurs formules structurelles, à savoir :
Procédé utile pour préparer une couche de graphène transparente et de conductivité électrique améliorée et stabilisée, ledit procédé comprenant au moins les étapes consistant à :
(i) disposer d'au moins une couche de graphène transparente et possédant une résistance carrée, Rsq.ini,
ladite couche de graphène étant disposée sur un substrat,
(ii) doper au moins une zone de ladite couche de graphène pour former une zone de graphène dopée ayant une résistance carrée stabilisée, Rsq. infini, de valeur inférieure à Rsq.ini,
caractérisé en ce que l'étape (ii) est réalisée par pulvérisation, en surface d'au moins ladite zone de ladite couche de graphène (i), d'au moins un dopant choisi parmi
- les sels de platine ou de palladium de formules :
A2MX6, MX4, A2MX4 et MX2
dans lesquelles :
- A est un atome d'hydrogène, un groupe NH4, un atome de sodium, un atome de lithium ou un atome de potassium ;
- X est un atome de fluor, un atome de chlore, un atome de brome ou un atome d'iode ; et
- M est un atome de platine ou un atome de palladium de degré d'oxydation +IV ou +II.

**EP 3 364 461 A1**

**ANNEXE AU RAPPORT DE RECHERCHE EUROPEENNE
RELATIF A LA DEMANDE DE BREVET EUROPEEN NO.**

EP 17 20 2863

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

13-07-2018

| Document brevet cité au rapport de recherche | | Date de publication | Membre(s) de la famille de brevet(s) | | Date de publication |
|---|---|---|---|---|---|
| US 2011127471 | A1 | 02-06-2011 | KR 20110061909 A<br>US 2011127471 A1 | | 10-06-2011<br>02-06-2011 |
| KR 20130099535 | A | 06-09-2013 | AUCUN | | |
| KR 20140143533 | A | 17-12-2014 | AUCUN | | |
| WO 2014065534 | A1 | 01-05-2014 | EP 2911977 A1<br>KR 20140060376 A<br>US 2014110670 A1<br>WO 2014065534 A1 | | 02-09-2015<br>20-05-2014<br>24-04-2014<br>01-05-2014 |

EPO FORM P0460

**EP 3 364 461 A1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20150162408 A1
- WO 2014065534 A1
- CN 102180463
- CN 104528698
- CN 104607344
- US 20150162408 A

**Littérature non-brevet citée dans la description**

- **BAE et al.** *Nature Nanotechnology,* 2010, vol. 5, 574
- **KIM et al.** *Nanotechnology,* 2010, vol. 21, 285205
- **KOBAYASHI et al.** *Appl. Phys. Lett.,* 2013, vol. 102, 023112
- **KHRAPACH et al.** *Adv. Mater.,* 2012, vol. 24, 2844
- **BAE et al.** *Nature Technology,* 2010, vol. 5, 574
- **SUK et al.** *ACS Nano,* 2011, vol. 5, 6916